(19)

Europäisches
Patentamt
European
Patent Office
Office européen
des brevets

(11)  **EP 4 503 412 A1**

(12)  **EUROPEAN PATENT APPLICATION**

(43) Date of publication:
**05.02.2025  Bulletin 2025/06**

(21) Application number: **23189712.5**

(22) Date of filing: **04.08.2023**

(51) International Patent Classification (IPC):
**H02M 1/00** (2006.01)      **H02M 3/156** (2006.01)
**H02M 3/335** (2006.01)

(52) Cooperative Patent Classification (CPC):
**H02M 1/0009; H02M 3/156; H02M 3/33507**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Infineon Technologies Austria AG
9500 Villach (AT)**

(72) Inventor: **HU, Jing
85579 Neubiberg (DE)**

(74) Representative: **Westphal, Mussgnug  & Partner,
Patentanwälte mbB
Werinherstraße 79
81541 München (DE)**

(54)  **POWER CONVERTER WITH A SENSING CIRCUIT AND METHOD**

(57)      A power converter and a method are disclosed. The power converter includes a converter circuit (1) with a first electronic switch (11) and a first inductor (12) connected in series with the first electronic switch (11); a control circuit (3) configured to control operation of the first electronic switch (11) and comprising a first input node (31); and a sense circuit (2). The sense circuit (2) includes a sense resistor (21) connected in series with the first electronic switch (11); a second inductor (22) inductively coupled with the first inductor (12) and coupled to the first input node (31) of the control circuit (3); and a first coupling circuit (23) coupling the sense resistor (21) to the first input node (31) of the control circuit (3). The first coupling circuit (23) includes a first resistor (25) coupled between the sense resistor (21) and the first input node (31), and a second electronic switch (26) connected in parallel with the first resistor (25). The control circuit (3) is further configured to control operation of the second electronic switch (26).

FIG 1

EP 4 503 412 A1

**Description**

This disclosure relates in general to a power converter, in particular a switched-mode power converter including a sense resistor and sense inductor.

A switched-mode power converter may include an electronic switch and an inductor connected in series with the electronic switch, a sense resistor connected in series with the electronic switch, and an auxiliary inductor inductively coupled with the inductor. The sense resistor may be used to sense a current through the electronic switch, and the auxiliary inductor may be used detect a magnetization state of the inductor. The information on the current through the electronic switch and information on the magnetization state of the inductor may be used to control operation of the electronic switch in order to regulate an output current or an output voltage of the power converter.

The power converter may further include a control circuit configured to control operation of the electronic switch and configured to receive the current information from the current sense resistor and the magnetization information from the auxiliary inductor.

There is a need for a power converter in which one and the same input pin of the control can be used to reliably receive the current sense information and the magnetization information.

One example relates to a power converter. The power converter includes a converter circuit with a first electronic switch and a first inductor connected in series with the first electronic switch; a control circuit configured to control operation of the first electronic switch and comprising a first input node; and a sense circuit. The sense circuit includes a sense resistor connected in series with the first electronic switch; a second inductor inductively coupled with the first inductor and coupled to the first input node of the control circuit; and a first coupling circuit coupling the sense resistor to the first input node of the control circuit. The first coupling circuit includes a first resistor coupled between the sense resistor and the first input node, and a second electronic switch connected in parallel with the first resistor. The control circuit is further configured to control operation of the second electronic switch.

Another example relates to a method. The method includes operating a sense circuit in a power converter in a first operating mode or a second operating mode. The power converter includes a converter circuit with a first electronic switch and a first inductor connected in series with the first electronic switch. The sense circuit includes a sense resistor connected in series with the first electronic switch; a first coupling circuit coupling the sense resistor to a first input node of a control circuit; and a second inductor inductively coupled with the first inductor and coupled to the first input node of the control circuit. The first coupling circuit includes a first resistor coupled between the sense resistor and the first input node, and a second electronic switch connected in parallel with the first resistor. Operating the sense circuit in the first operating mode includes operating the second electronic switch in an on-state, and operating the sense circuit in the second operating mode includes operating the second electronic switch in an off-state.

Examples are explained below with reference to the drawings. The drawings serve to illustrate certain principles, so that only aspects necessary for understanding these principles are illustrated. The drawings are not to scale. In the drawings the same reference characters denote like features.

Figure 1 Illustrates one example of a power converter that includes a converter circuit with a first electronic switch, a control circuit, and a sense circuit with a second electronic switch;

Figure 2 illustrates one example of the sense circuit in greater detail;

Figures 3A and 3B illustrates examples for implementing the first and second electronic switches;

Figure 4 illustrates one example of a converter circuit that includes a boost converter topology;

Figure 5 illustrates one example of a converter circuit that includes a flyback converter topology;

Figure 6 illustrates one example of a feedback circuit;

Figure 7 illustrates one example for generating a rectified alternating voltage based on an alternating voltage;

Figure 8 shows signal diagrams that illustrate one example for operating the power converter in a continuous conduction mode (CCM);

Figure 9 shows signal diagrams that illustrate one example for operating the power converter in a critical conduction mode (CrCM); and

Figure 10 shows signal diagrams that illustrate one example for operating the power converter in a quasi-resonant mode (QRM).

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

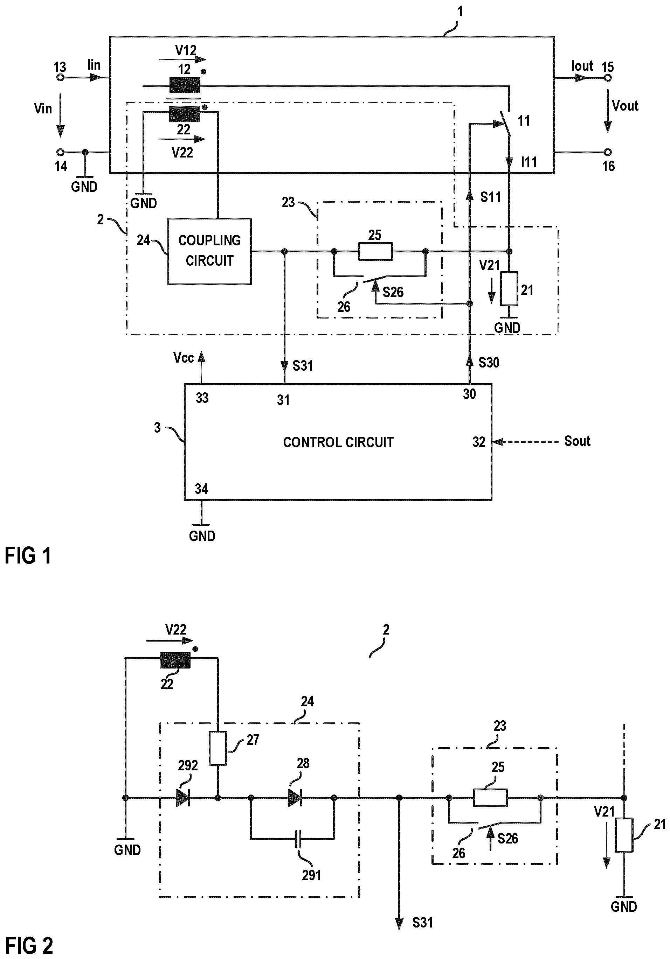

Figure 1 illustrates one example of a power converter, in particular a switched-mode power converter. More specifically, Figure 1 schematically illustrates a circuit diagram of the power converter according to one example. The power converter includes a converter circuit 1, a sense circuit 2, and a control circuit 3. The converter circuit 1 includes a first electronic switch 11 and a first inductor 12 connected in series with the first electronic switch 11. The control circuit 3 is configured to control operation of the power converter by controlling operation of the first electronic switch 11 and includes a first input node 31 connected to the sense circuit 2.

Referring to Figure 1, the sense circuit 2 includes a sense resistor 21 connected in series with the first electronic switch 11, a second inductor 22 inductively coupled with the first inductor 12, a first coupling circuit 23 coupling the sense resistor 21 to the first input node 31 of the control circuit 3, and a second coupling circuit 24 coupling the second inductor 22 to the first input node 31 of the control circuit. The first coupling circuit 23 includes a first resistor 25 coupled between the sense resistor 21 and the first input node 31, and an electronic switch 26 connected in parallel with the first resistor 25. The control circuit 3, in addition to controlling operation of the first electronic switch 11, is further configured to control operation of the second electronic switch 26 of the second coupling circuit 23.

According to one example, the first and second inductors 21, 22 have same winding sentences, so that a voltage V22 across the second inductor 22 has the same polarity as a voltage V21 across the first inductor 21. The voltage V22 across the second inductor 22 is essentially proportional to the voltage V21 across the first inductor 21, wherein a proportionality factor is given by a winding ratio of the first and second inductors 21, 22.

Each of the first and second electronic switches 11, 26 includes a control input and a load path. The first electronic switch 11 is configured to switch on or off dependent on a first a drive signal S11 received at its control input, and the second electronic switch 26 is configured to switch on or off dependent on a second drive signal S26 received at its control input. The load path of the first electronic switch 11 is a circuit path that is connected in series with the first inductor 12 and the sense resistor 21. The load path of the second electronic switch 26 is a circuit path that is connected in parallel with the first resistor 25 and is connected between the sense resistor 21 and the first input node 31 of the control circuit 3.

For controlling the first and second electronic switches 11, 26, the control circuit 3 includes an output node 30, which may also be referred to as drive output. The control circuit 3 is configured to provide a switch drive signal S30 at the drive output 30, wherein the first and second electronic switches 11, 26 are driven based on the switch drive signal S30. This includes that the first and second drive signals S11, S26 are generated based on the switch drive signal S30. The first and second drive signals S11, S26 may be identical and identical with the switch drive signal S30, as illustrated in Figure 1. This, however, is only an example. Further examples for generating the first and second drive signals S11, S26 based on the switch drive signal S30 are explained herein further below.

Referring to Figure 1, the converter circuit 1 includes an input 13, 14 configured to receive an input voltage Vin and an input current Iin, and an output 15, 16 configured to provide an output voltage Vout and an output current Iout. Within the converter circuit 1, the series circuit including the first inductor 12 and the first electronic switch 11 is connected to the input 13, 14 such that the first inductor 12 is being magnetized when the first electronic switch 11 is in an on-state (switched-on state) and the first inductor 12 is being demagnetized when the first electronic switch 11 subsequently is in an off-state (switched off-state). Different examples for interconnecting the series circuit with the first electronic switch 11 and the first inductor 12 within the converter circuit 1 are explained herein further below.

Magnetizing the first inductor 12 during the on-state of the first electronic switch 11 is associated with storing energy received from the input 13, 14 in the first inductor 12, and demagnetizing the first inductor 12 during the off-state of the first electronic switch 11 is associated with transferring at least a portion of the energy stored in the first inductor 12 to the output 15, 16. The control circuit 3 is configured to operate the first electronic switch 11 in a switched-mode. This includes operating the first electronic switch 11 in plurality of successive drive cycles, wherein each drive cycle includes an on-time in which the first electronic switch 11 is in the on-state and an off-time in which the first electronic switch 11 is in the off-state. A duty cycle d of the switched-mode operation of the first electronic switch 11 is given by a duration Ton of the on-time divided by a duration T of one drive cycle,

$$d = \frac{Ton}{T} \quad (1).$$

In the converter circuit 1, a power flow from the input 13, 14 to the output 15, 16 can be controlled by controlling the duty cycle of the switched mode operation of the first electronic switch 11.

According to one example, the control circuit 3 is configured to control operation of the power converter such that one of the output voltage Vout and the output current Iout is regulated. For this, the control circuit receives a current sense signal V21 from the sense resistor 21, and a magnetizing signal V22 from the second inductor 22. The current sense signal V21 is a voltage across the sense resistor 21, and the magnetizing signal is the voltage V22 across the second inductor 22. The current sense signal V21 includes information on a current level of a current I11 through the first electronic switch 11 when the first electronic switch 11 is in the on-state. The magnetizing signal includes information on a magnetization state of the first inductor 12. In particular, the magnetizing signal includes information on time instances at which the first inductor 12 has been demagnetized. The current signal V21 and the magnetizing signal V22 are both received at the first input 31 of the control circuit 3.

Optionally, the control circuit 3 may further receive a feedback signal Sout at a feedback input 32. The feedback signal Sout represents the output voltage Vout or the output current Iout, whichever is to be regulated. According to one example, the feedback signal Sout is proportional to the output voltage Vout or the output current Iout, whichever is to be regulated.

Based on the current signal V21, the magnetizing signal V22, and the optional feedback signal Sout the control circuit 3 adjusts the duty cycle of the switched mode operation of the first electronic switch 11 in order to regulate the output voltage Vout or the output current Iout.

Referring to the above, the current sense signal V21 and the magnetizing signal V22 are received by the control circuit 3 at the first input 31. The current sense signal V21 represents the current I11 through the first electronic switch 11 during the on-state of the first electronic switch 1. During the off-state of the electronic switch 11, the sense signal S31 represents the magnetizing signal V22.

The current sense signal V21 may be used for detecting an overcurrent and/or regulating the output voltage Vout or the output current Iout. This is explained herein further below.

Referring to Figure 1, the input voltage Vin is a voltage that is referenced to a reference node GND, which is also referred to as ground node in the following. The voltage across the second inductor 22 representing the magnetizing signal V22 and the voltage across the sense resistor 21 representing the current sense signal V21 are also voltages referenced to the ground node GND. According to one example, the control circuit 3 is connected to the ground node at a reference node 34, and the first input node 31 is high-ohmically coupled to the reference node 34, so that the sense signal S31 is a voltage referenced to the ground node GND.

In the power converter according to Figure 1, the sense circuit 2 is configured to operate either in a first operating mode or a second operating mode.

The sense circuit 2 is in the first operating mode when the first electronic switch 11 and the second electronic switch 26 are in the on-state. In this operating mode, the electronic switch 26 bypasses the first resistor 25 and directly connects the sense resistor 21 to the first input node 31 of the control circuit 3, so that the sense signal S31 received at the first input node 31 essentially equals the current sense signal V21. As explained in detail herein further below, the second coupling circuit 24 is configured to decouple the second inductor 22 from the first input node 31 in the first operating mode, so that in the first operating mode the sense signal S31 received at the first input node 31 of the control circuit 3 is governed by the current sense signal V21. The sense circuit 2 is in the first operating mode at least during a portion of the time period in which the first electronic switch 11 is in the on-state, so that the current sense signal V21 represents the current I11 through the electronic switch 11 when the sense circuit 2 is in the first operating mode.

The sense circuit 2 is in the second operating mode when the first electronic switch 11 and the second electronic switch 26 are in the off-state. In this operating mode a series circuit including the second coupling circuit 24, the first resistor 25 of the first coupling circuit 23, and the sense resistor 21 couple the second inductor 22 to the ground node GND. According to one example, a resistance R25 of the first resistor 25 is significantly higher than a resistance R21 of the sense resistor 21. According to one example, the resistance R25 of the first resistor 25 is at least 10 times, at least 100 times, or at least 1000 times the resistance R21 of the sense resistor 21. In order to reduce conduction losses it is desirable to implement the sense resistor 21 with a low resistance R21. According to one example, the resistance R21 of the sense resistor is selected from a range of between 100 milliohms and 500 milliohms.

The first resistor 25 with the high resistance R25 ensures that the second inductor 22, in the off-state of the first electronic switch 11, provides a sufficiently high signal level of the sense signal S31 at the first input node 31 of the control circuit 3.

Referring to Figure 1, the control circuit 3 may further include a supply node 33 that is configured to receive a supply voltage Vcc for powering the control circuit 3. The supply voltage Vcc is references to the ground node GND, for example.

Figure 2 illustrates one example of the second coupling circuit 24 in greater detail. In the example illustrated in Figure 2, the second coupling circuit 24 includes a second resistor 27 and a rectifier element 28 that are connected in series between the second inductor 22 and the first coupling circuit 23. A resistance of the second resistor 27 is selected from the same range as the resistance of the first resistor 25, for example.

The rectifier element 28 is a diode, for example, wherein a polarity of the rectifier element 28 is such that the rectifier element 28 decouples the auxiliary winding 22 from the first input node 31 of the control circuit 3 when the electronic switch 11 is in the on-state. When the first electronic switch 11 is in the on-state, the voltage V22 across the second inductor 22 has a polarity as illustrated in Figure 2. In this operating state, the rectifier element 28 is blocking and is decoupling the second inductor 22 from the first input node 31.

Referring to Figure 2, the second coupling circuit 24 may further include a capacitor 291 connected parallel to the rectifier element 28. This capacitor 291 is optional and helps to improve the dynamic behavior of the sense circuit 2.

Furthermore, a further rectifier element 292, such as a diode, may be connected in parallel with a series circuit including the second inductor 22 and the second resistor 27. According to one example, a polarity of this further rectifier element 292 is such that the further rectifier element 292 clamps the voltage at the connecting point of the further rectifier element 292, the second resistor 27, and the rectifier element 28 when the first electronic switch 11 is in the on-state. In this operating state, the voltage V22 across the second inductor 22 has a polarity opposite the polarity illustrated in Figure 2.

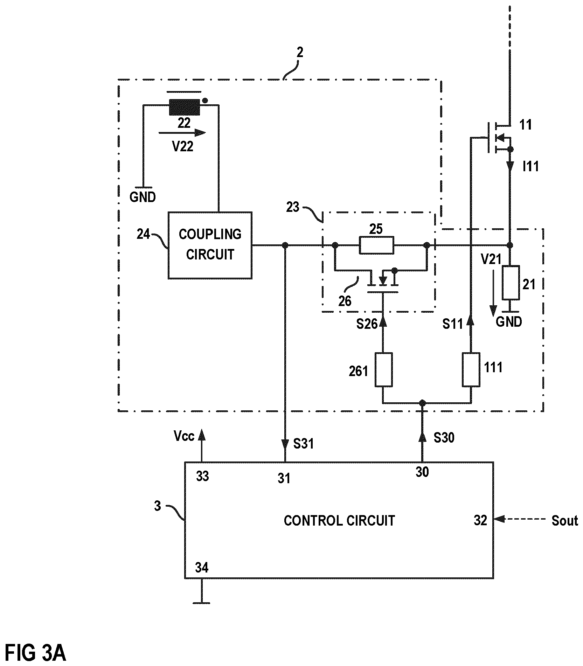

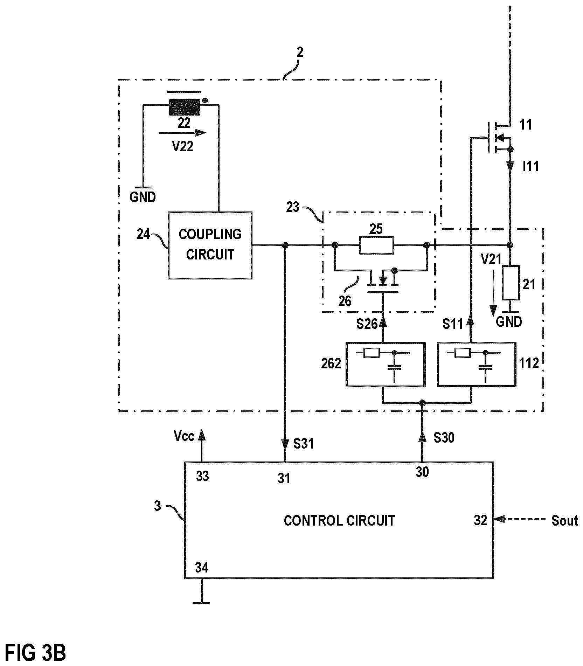

Any type of electronic switch may be used to implement the first and second electronic switches 11, 26. According to one example illustrated in Figures 3, each of the first and second electronic switches 11, 26 is a transistor device such as, for example, a MOSFET (Metal Oxide Semiconductor Field-Effect Transistor). Just for the purpose of illustration, in the examples illustrated in Figures 3A and 3B each of the first and second electronic switches 11, 26 is an N-type enhancement MOSFET. This, however, is only an example. Any other type of transistor device may be used as well in order to implement the first and second electronic switches 11, 26.

As illustrated in Figures 3A and 3B, the same type of transistor device may be used to implement the first and second electronic switches 11, 26. This, however, is only an example. It is also possible to implement the first electronic switch 11 using a first type of transistor device and to implement the second electronic switch 26 using a second type of transistor device.

In the example illustrated in Figures 3A and 3B, the load path of the first electronic switch 11 is a drain-source path of the MOSFET forming the first electronic switch 11, and the control node of the first electronic switch 11 is a gate node of the MOSFET forming the first electronic switch 11. Equivalently, the load path of the second electronic switch 26 is a drain-source path of the MOSFET forming the second electronic switch 26, and the control node of the second electronic switch 26 is a gate node of the MOSFET forming the second electronic switch 26.

In the example illustrated in Figure 3A, the control node of the first electronic switch 11 is connected to the drive node 30 via a first gate resistor 111, and the control node of the second electronic switch 26 is connected to the drive node 30 via a second gate resistor 261. According to one example, resistances R261, R111 of first and second gate resistors 111, 261 are essentially the same.

According to another example, the resistance R261 of the second gate resistor 261 is higher than the resistance R111 of the first gate resistor 111. In this example, the first electronic switch 11 switches on faster than the second electronic switch 26 when the drive signal S30 changes from an off-level to an on-level. The "off-level" of the drive signal S30 is a signal level that switches off the first and second electronic switches 11, 26, and the "on-level" of the drive signal S30 is a signal level that switches on the first and second electronic switches 11, 26.

According to another example illustrated in Figure 3B, the control node of the first electronic switch 11 is connected to the drive node 30 via a first RC network 112, and the control node of the second electronic switch 26 is connected to the drive node 30 via a second RC network 262. Each of the first and second RC networks 112, 262 includes at least one capacitor and at least one resistor. Each of the RC networks 112, 262 is configured to generate, based on the drive signal S30 provided by the control circuit 3, a drive signal S11, S26 that is suitable to drive the respective first or second electronic switch 11, 26. As explained hereinabove, the two electronic switches 11, 26 may be implemented as different types of electronic switches. In this case, the RC networks 112, 262 can be implemented differently way, each suitable to drive the respective electronic switch 11, 26.

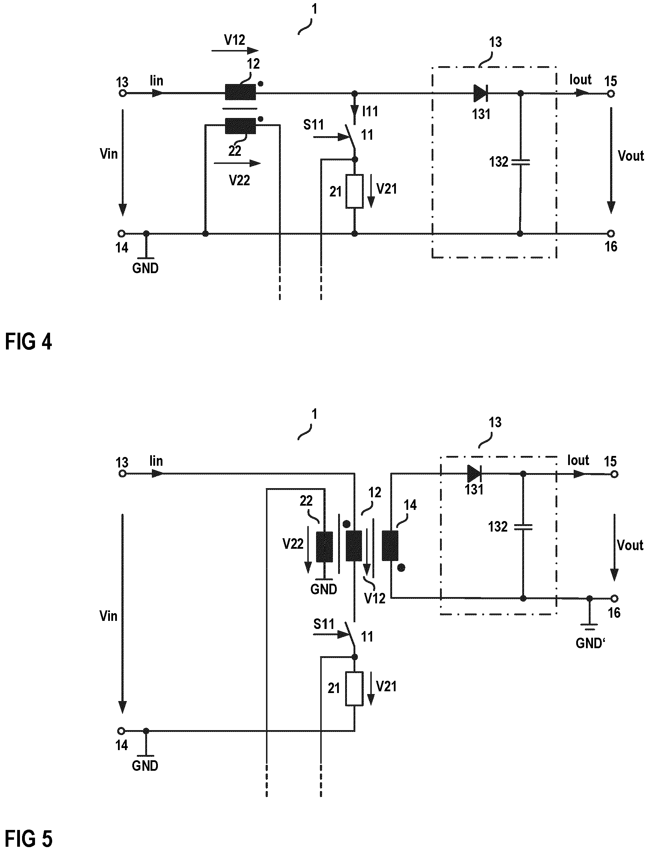

The converter circuit 1 with the series circuit including the first electronic switch 11 and the first inductor 12 may be implemented in various ways. Two different examples are explained with reference to Figures 4 and 5 in the following.

In the example illustrated in Figure 4, the power converter is a boost converter. In this example, the series circuit including the first electronic switch 11, the first inductor 12, and the sense resistor 21 is connected between first and second input nodes 13, 14 of the input, so that the series circuit receives the input voltage Vin. In this circuit, the voltage V12 across the first inductor 12 essentially equals the input voltage Vin when the first electronic switch 11 is in the on-state. In addition to the series circuit with the first electronic switch 11 and the first inductor 12, the converter circuit 1 includes a rectifier circuit 13 that is connected in parallel with the first electronic switch 11. More specifically, the rectifier circuit 13 is connected in parallel with the series circuit including the first electronic switch 11 and the sense resistor 21. The rectifier circuit 13 provides the output voltage Vout and the output current Iout.

The rectifier circuit 13 may be implemented in various ways. Just for the purpose of illustration, one example for implementing the rectifier circuit 13 is illustrated in Figure 4. In this example, the rectifier circuit 13 includes a series circuit including a rectifier element 131, such as a diode, and a capacitor 132, wherein the series circuit is connected in parallel with the series circuit including the first electronic switch 11 and the sense resistor 21. The output voltage Vout is available across the capacitor 132.

In the boost converter according to Figure 4, the output voltage Vout, for example, can be regulated by suitably controlling the input current Iin. The input current Iin can be controlled by controlling the switched mode operation of the electronic switch 11. In the boost converter according to Figure 4, the first inductor 12 is being magnetized when the first electronic switch 11 is in the on-state. In this operating state, the input current Iin equals the current I11 through the first electronic switch 11. The first inductor 12 is being demagnetized when the first electronic switch 11 is in the off-state. In this operating state, the input current Iin continues to flow through the rectifier circuit 13 to the output 15, 16. The boost converter topology illustrated in Figure 4 and its functionality are commonly known, so that no further explanation is required in this regard.

In the example illustrated in Figure 5, the power converter is a flyback converter. In this example, the series circuit including the first electronic switch 11, the first inductor 12, and the sense resistor 21 is connected between the first and second input nodes 13, 14 of the input. The first inductor 12 is a primary winding of a transformer. The transformer further includes a secondary winding that is inductively coupled with the primary winding. The primary winding 12 and the secondary winding 14 have opposite winding senses. The rectifier circuit 13 is connected in parallel with the secondary winding 14. The transformer with the primary winding and the secondary winding provides for a galvanic isolation between the input 13, 14 and the output 15, 16, so that the output voltage Vout is referenced to a reference potential GND' that is different from the reference potential GND to which the input voltage Vin is referenced to.

In the flyback converter according to Figure 5, the output voltage Vout, for example, can be regulated by suitably controlling the input current Iin, wherein the input current Iin is controlled by the switched mode operation of the electronic switch 11. In the flyback converter according to Figure 5, the first inductor 12 is being magnetized when the first electronic switch 11 is in the on-state. In this operating mode, the input current Iin equals the current I11 through the first electronic switch 11. The first inductor 12 is being demagnetized when the first electronic switch 11 is in the off-state. In this operating state, the input current Iin is zero and the secondary winding 14 drives a current through the rectifier element 13 to the output 15, 16. The flyback converter topology illustrated in Figure 5 and its functionality is commonly known, so that no further explanation is required in this regard.

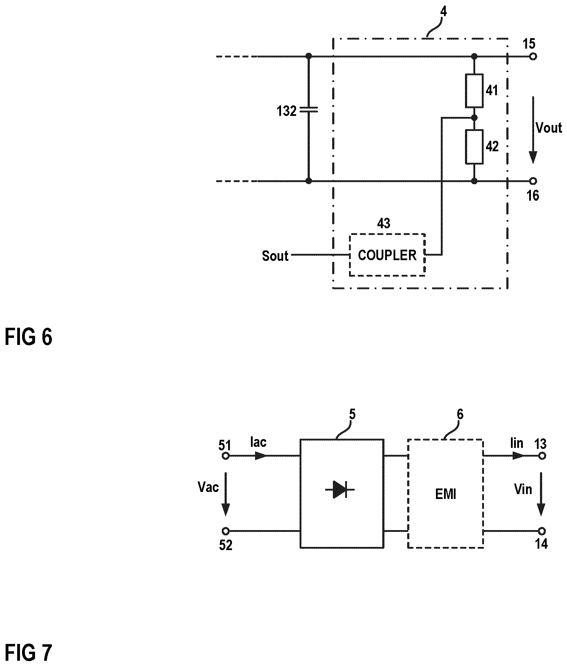

Referring to Figure 1 and the corresponding description, the control circuit 3 may receive a feedback signal Sout that represents the output signal that is to be regulated. That is, the feedback signal Sout either represents the output voltage Vout or the output current Iout, whichever is to be regulated. The power converter may include a feedback circuit for generating the feedback signal Sout dependent on the respective output signal. One example of a feedback circuit 4 that is configured to generate the feedback signal Sout dependent on the output voltage Vout is illustrated in Figure 6.

In the example illustrated in Figure 6, the feedback circuit 4 includes a voltage divider with first and second resistors 41, 42 connected in series between the output nodes 15, 16. The feedback signal Sout is the voltage across one of the two resistors 41, 42. Optionally, the feedback circuit 4 includes a coupling circuit 43 connected between the voltage divider 41, 42 and the control circuit 3 (not illustrated in Figure 6). The coupling circuit 43 is configured to transfer the feedback signal Sout across a galvanic isolation, such as a galvanic isolation in a flyback converter. For this, the coupling circuit 43 includes an optocoupler, for example.

Generating the feedback signal Sout representing the output voltage Vout using a voltage divider connected to the output nodes 15, 16, however, is only an example. According to another example (not illustrated) the feedback signal Sout is generated based on a voltage V22 across the second inductor 22. In a flyback converter, for example, the voltage V22 across the second inductor 22 is essentially proportional to the output voltage Vout during the off-time of the electronic switch 11, so that the voltage V22 across the second inductor 22 may be used to obtain output voltage information.

According to one example, the input voltage Vin is a direct voltage (DC voltage). According to another example, the input voltage Vin is a rectified alternating voltage such as, for example, a rectified sinusoidal voltage. Figure 7 illustrates one example of an input circuit of the power converter that is configured to generate the input voltage Vin based on an alternating voltage Vac, such as a sinusoidal voltage.

Referring to Figure 7, the input circuit includes a rectifier 5 with input nodes 51, 52 that are configured to receive the alternating voltage Vac. The rectifier 5 is configured to provide the rectified alternating voltage as the input voltage Vin to the input nodes 13, 14. The rectifier 5 may include a conventional passive rectifier bridge. This, however, zone an example. Other types of rectifiers 5 configured to rectify an alternating voltage may be used as well. Optionally, the input circuit further includes an EMI (electromagnetic interference) filter connected between the rectifier 5 and the input nodes 13, 14. The EMI filter 6 is configured to filter high-frequency components included in the input current Iin and the input voltage Vin, wherein such high-frequency signal components may result from the switched mode operation of the power converter.

According to one example, the power converter is a PFC converter. In this example, the control circuit 3 is not only configured to control operation of the power converter such that the output voltage Vout or the output current Iout is, but the control circuit 3 is also configured to control operation of the power converter such that a waveform of an average input current is in accordance with the waveform of the input voltage Vin. The "average input current" is the average of the input current Iin over one or more drive cycles of the switched mode operation of the power converter. According to one example, the average input current is proportional to the input voltage Vin.

In a PFC converter, the control circuit 3, in addition to the sense signal S31 and the output signal Sout, may receive an input signal (not illustrated in the drawings) that represents the input voltage Vin and is used by the control circuit 3 in order to control the input current Iin dependent on the voltage level of the input voltage Vin. This is basically known in the PFC converter, so that no further explanation is required in this regard.

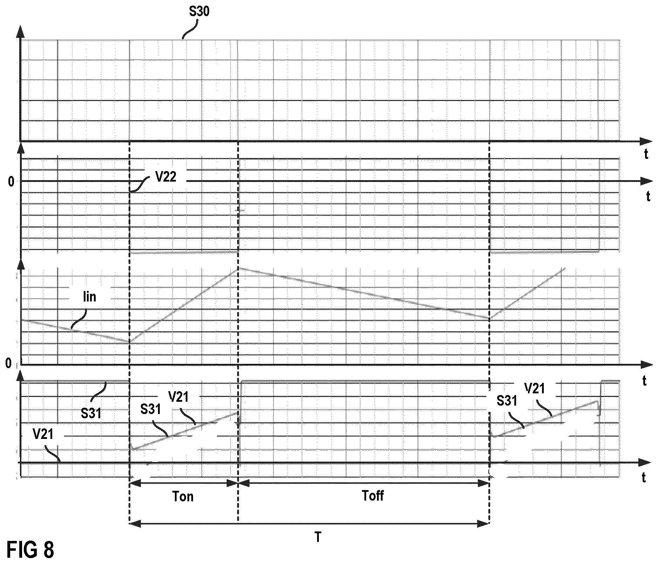

The power converter may operate in different operating modes. Three different operating modes are explained in the following with reference to timing diagrams illustrated in Figures 8 to 10. These timing diagrams relate to operating a boost converter of the type illustrated in Figure 4 in three different operating modes, a continuous conduction mode (CCM), a critical conduction mode (CrCM), and a quasi-resonant mode (QRM). Each of the timing diagrams shows the drive signal S30 provided by the control circuit 3, the input current Iin, the voltage V22 across the second inductor 22, the sense signal S31 at the first input node 31 of the control circuit 3, and the current sense signal V22.

Referring to the above, the drive signal S30 for operating the first and second electronic switches 11, 26 either has an on-level that switches on the first and second switches 11, 26, or an off-level that switches off the first and second switches 11, 26. Just for the purpose of illustration, in the examples illustrated in Figures 8 to 10, the on-level is a high signal level and the off-level is a low signal level.

In each of the different operating modes illustrated in Figures 8 to 10, operating the power converter includes operating the power converter in a plurality of successive drive cycles, wherein each drive cycle includes an on-time in which the first electronic switch 11 is in the on-state followed by an off-time in which the first electronic switch 11 is in the off-state. The different operating states are different with regard to the timing of again switching on the first electronic switch 11, that is, with regard to the timing of starting a new drive cycle.

In each of the three operating modes, a duration Ton of the on-time may be adjusted by the control circuit 3 dependent on the feedback signal Sout. According to one example, the control circuit 3 is configured to detect a power consumption of a load (not illustrated) connected to the output nodes 15, 16 based on the feedback signal Sout and is configured to select one of the three operating modes dependent on the power consumption of the load. According to one example, the power converter operates in CCM under high load conditions, in CrCM under medium load conditions, and in QRM under low load conditions.

In each of the three operating modes, the current sense signal V21 may be used by the control circuit 3 to detect an overcurrent scenario. According to one example, the control circuit 3 is configured to switch off the first electronic switch 11 whenever the current sense signal reaches a predefined current level indicating that an overcurrent scenario has occurred.

According to another example, the current sense signal V21 is used for controlling the output voltage of the output current Vout, Iout. In this example, a current threshold is generated based on the feedback signal Sout and the first electronic switch 11 is a switched off each time, the current I11 so the first electronic switch 11 reaches the current threshold generated based on the feedback and signal Sout. This type of operating mode of the power converter is usually referred to as current mode.

Figure 8 shows signal diagrams that illustrate one example for operating the power converter in the CCM. In this operating mode, the input current Iin increases during the on-time and decreases during the off time. In Figure 8, Ton denotes the duration of the on-time in one drive cycle, Toff denotes the duration of the off-time in one drive cycle, and T denotes an overall duration of the drive cycle. In the CCM, a new on-time (a new drive cycle) starts before the input current Iin has decreased to zero during the off-time. Thus, during the off-time, the first inductor 12 is not being entirely demagnetized.

In CCM, during the on-time, the voltage V22 across the second inductor 22 is proportional to the input voltage and, during the off-time, the voltage V22 across the second inductor 22 is proportional to a voltage that is given by the output voltage Vout minus the input voltage Vin, $V22 \sim Vout - Vin$.

In CCM, the magnetizing signal V22 is not required by the control circuit 3 to regulate the output voltage Vout or the output current Iout. Furthermore, the control circuit 3 may operate the power converter at a fixed switching frequency. This includes that the overall duration T of each drive cycle is the same,

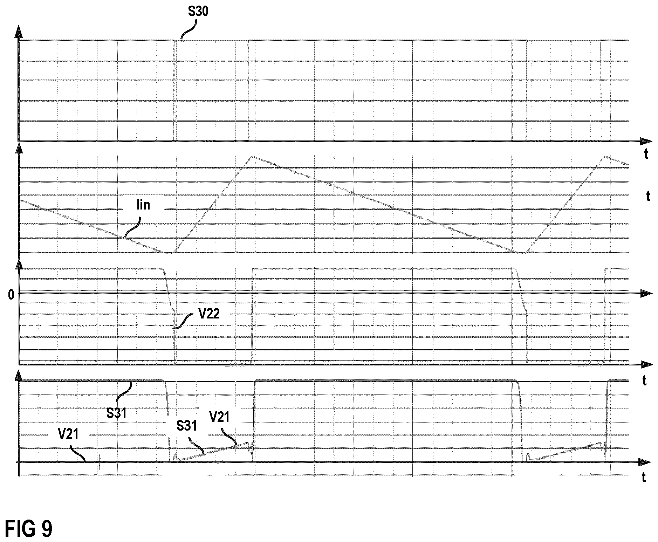

Figure 9 shows signal diagrams that illustrate one example for operating the power converter in the CrCM. In this operating mode, the input current Iin increases during the on-time and decreases during the off-time. Furthermore, in this operating mode, the duration of the off-time is selected such that the first inductor 12 is being entirely demagnetized during the off-time, so that the input current Iin decreases to zero during the off-time. In CrCM, the control circuit 3 uses the magnetizing signal V22 to detect, during the off-time, the time instance when the first inductor 12 has been completely demagnetized. Furthermore, the control circuit 3 is configured to again switch on the first electronic switch 11 after a predefined time duration after having detected that the first inductor 12 has been demagnetized.

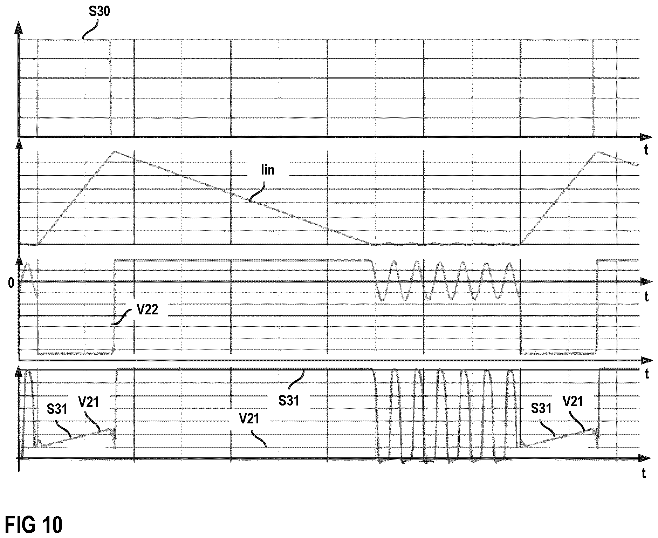

Figure 10 shows signal diagrams that illustrate one example for operating the power converter in the QRM. In this operating mode, the input current Iin increases during the on-time, decreases during the off-time and is essentially zero for a certain time period towards the end of the off-time. In this operating mode, the first inductor 12 is completely being demagnetized during the off-time. After the first inductor 12 has been demagnetized, parasitic oscillations of the voltage V12 across the first inductor 12 may occur. Equivalently, parasitic oscillations of the magnetizing signal V22 may occur. In this operating mode, the control circuit 3 is configured to start a new drive cycle after a predefined number of periods of the parasitic oscillations have occurred, that is, after a predefined number of zero-crossings of the magnetizing signal V22 have occurred. The number of zero-crossings that are allowed to occur before a new drive cycle starts is dependent on the power consumption of the load and increases as the power consumption of the load decreases.

As can be seen from Figures 8 to 10, during the on-time of the first electronic switch 11, the sense signal S31 received at the first input node 31 of the control circuit 3 follows the current sense signal V21. More specifically, the sense signal S31 essentially equals the current sense signal V21. The first input node 31 has an input capacitance (not illustrated in the drawings). The input capacitance together with the sense resistor 21 forms an RC element. At the beginning of the on-time, the input capacitance is discharged so that the sense signal S31 is zero. The input capacitance is rapidly charged at the beginning of the on-time, so that the sense S31 rapidly increases and tracks the current sense signal V21, wherein there is only a small difference, if any, between the current sense signal V21 and the sense signal S31.

In the power converter explained herein before, the pin count of the control circuit 3 can be reduced by using the same first input pin 31 for receiving both the current sensors signal V21 representing the current I11 through the first electronic switch 11, and the magnetizing signal V22, which is given by the voltage across the second inductor 22. The second electronic switch 26 ensures that the sense signal S31 received at the first input node 31 essentially equals the current sense signal V21 during the on-state of the second electronic switch 26, so that the sense signal S31 is not distorted by the presence of the first resistor 25.

Some aspects of the power converter and the method explained herein before are summarized in the following.

According to one example, the power converter includes a converter circuit including a first electronic switch and a first inductor connected in series with the first electronic switch, a control circuit configured to control operation of the first electronic switch and including a first input node, and a sense circuit. The sense circuit includes a sense resistor connected in series with the first electronic switch, a second inductor inductively coupled with the first inductor and coupled to the first input node of the control circuit, and a first coupling circuit coupling the sense resistor to the first input node of the control circuit. The first coupling circuit includes a first resistor coupled between the sense resistor and the first input node, and a second electronic switch connected in parallel with the first resistor. The control circuit is further configured to control operation of the second electronic switch.

The second inductor may be coupled to the first input node via a second coupling circuit, wherein the second coupling circuit includes a second resistor coupled between the second inductor and the first input node. The second coupling circuit may further include a rectifier element connected in series with the second resistor. The second coupling circuit may further include a capacitor connected in parallel with the rectifier element.

According to one example, the converter circuit has a boost converter topology. According to another example, the converter circuit has a flyback converter topology.

The control circuit may be configured to operate the second electronic switch in an on-state at least during a portion of a time period in which the first electronic switch is in an on-state. According to one example, the control circuit is configured to synchronously switch on and off the first and second electronic switches.

According to one example, a method for operating a sense circuit in a power converter includes operating the sense circuit in a first operating mode or a second operating mode. The power converter includes a converter circuit with a first electronic switch and a first inductor connected in series with the first electronic switch. The sense circuit includes a sense resistor connected in series with the first electronic switch, a first coupling circuit coupling the sense resistor to a first input node of a control circuit, and a second inductor inductively coupled with the first inductor and coupled to the first input node of the control circuit. The first coupling circuit includes a first resistor coupled between the sense resistor and the first input node, and a second electronic switch connected in parallel with the first resistor. Operating the sense circuit in the first operating mode includes operating the second electronic switch in an on-state, and operating the sense circuit in the second operating mode includes operating the second electronic switch in an off-state.

The method may further include operating the first electronic switch in a plurality of drive cycles each including an on-time in which the first electronic switch is in an on-state and an off-time in which the first electronic switch is in an off-state, wherein operating the sense circuit in the first operating mode further includes operating the sense circuit in the first operating mode at least during a portion of the on-time of the first electronic switch. The method may further include monitoring a sense signal received at the first input node of the control circuit at least during a portion of the off-time, and starting a new drive cycle dependent on the monitored sense signal.

According to one example, the method further includes monitoring a sense signal received at the first input node of the control circuit at least during a portion of the on-time, and switching off the first electronic switch when the sense signal reaches a predefined threshold.

**Claims**

1. A power converter, comprising:

   a converter circuit (1) comprising a first electronic switch (11) and a first inductor (12) connected in series with the first electronic switch (11);
   a control circuit (3) configured to control operation of the first electronic switch (11) and comprising a first input node (31); and
a sense circuit (2),
wherein the sense circuit (2) comprises:

a sense resistor (21) connected in series with the first electronic switch (11);
a second inductor (22) inductively coupled with the first inductor (12) and coupled to the first input node (31) of the control circuit (3); and
a first coupling circuit (23) coupling the sense resistor (21) to the first input node (31) of the control circuit (3),
wherein the first coupling circuit (23) comprises a first resistor (25) coupled between the sense resistor (21) and the first input node (31), and a second electronic switch (26) connected in parallel with the first resistor (25), and
wherein the control circuit (3) is further configured to control operation of the second electronic switch (26).

2. The power converter according to claim 1,

wherein the second inductor (22) is coupled to the first input node (31) via a second coupling circuit (24),
wherein the second coupling circuit (24) comprises a second resistor (27) coupled between the second inductor (22) and the first input node (31).

3. The power converter according to claim 2, wherein the second coupling circuit (24) further comprises a rectifier element (28) connected in series with the second resistor (27).

4. The power converter according to claim 3, wherein the second coupling circuit (24) further comprises a capacitor (291) connected in parallel with the rectifier element (28).

5. The power converter according to any one of claims 1 to 4,
wherein the converter circuit (2) has a boost converter topology.

6. The power converter according to any one of claims 1 to 4,
wherein the converter circuit (1) has a flyback converter topology.

7. The power converter according to any one of the preceding claims,
wherein the control circuit (3) is configured to operate the second electronic switch (26) in an on-state at least during a portion of a time period in which the first electronic switch (11) is in an on-state.

8. The power converter according to claim 7,
wherein the control circuit (3) is configured to synchronously switch on and off the first and second electronic switches.

9. A method, comprising:

operating a sense circuit (2) in a power converter in a first operating mode or a second operating mode,
wherein the power converter comprises a converter circuit (1) with a first electronic switch (11) and a first inductor (12) connected in series with the first electronic switch (11),
wherein the sense circuit (2) comprises:

a sense resistor (21) connected in series with the first electronic switch (11);
a first coupling circuit (23) coupling the sense resistor (21) to a first input node (31) of a control circuit (3); and
a second inductor (22) inductively coupled with the first inductor (12) and coupled to the first input node (31) of the control circuit (3),
wherein the first coupling circuit (23) comprises a first resistor (25) coupled between the sense resistor (21) and the first input node (31), and a second electronic switch (26) connected in parallel with the first resistor (25),
wherein operating the sense circuit (2) in the first operating mode comprises operating the second electronic switch (26) in an on-state, and
wherein operating the sense circuit (2) in the second operating mode comprises operating the second electronic switch (26) in an off-state.

10. The method according to claim 9, further comprising:

operating the first electronic switch (11) in a plurality of drive cycles each comprising an on-time in which the first electronic switch (11) is in an on-state and an off-time in which the first electronic switch (11) is in an off-state,
wherein operating the sense circuit (2) in the first operating mode further comprises operating the sense circuit (2) in the first operating mode at least during a portion of the on-time of the first electronic switch (11).

11. The method according to claim 10, further comprising:

monitoring a sense signal (S31) received at the first input node (31) of the control circuit (3) at least during a portion of the off-time, and starting a new drive cycle dependent on the monitored sense signal (S31).

12. The method according to claim 10 or 11, further comprising:

monitoring a sense signal (S31) received at the first input node (31) of the control circuit (3) at least during a portion of the on-time, and switching off the first electronic switch (11) when the sense signal (S31) reaches a predefined threshold.

FIG 1

FIG 2

FIG 3A

FIG 3B

FIG 4

FIG 5

FIG 6

FIG 7

S30

V22

0

Iin

0

S31

S31

V21

V21

S31

V21

V21

Ton

Toff

T

t

t

t

t

**FIG 8**

FIG 9

EP 4 503 412 A1

FIG 10

Europäisches
Patentamt

European
Patent Office

Office européen
des brevets

# EUROPEAN SEARCH REPORT

Application Number

EP 23 18 9712

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/300306 A1 (MARENT GUENTER [AT] ET AL) 14 November 2013 (2013-11-14) | 1,2,5-12 | INV.<br>H02M1/00 |
| Y | * figure 8 *<br>* paragraph [0017] - paragraph [0031] *<br>* paragraph [0064] *<br>* paragraph [0075] * | 3,4 | H02M3/156<br>H02M3/335 |
| Y | US 2008/130327 A1 (YAN HUAI-ZHU [CN] ET AL) 5 June 2008 (2008-06-05) | 3,4 | |
| A | * figure 1 *<br>* paragraph [0022] - paragraph [0040] * | 1,2,5-12 | |
| Y | US 2014/218978 A1 (HEUKEN TOBIAS [DE] ET AL) 7 August 2014 (2014-08-07) | 3,4 | |
| A | * figure 1 *<br>* paragraph [0034] - paragraph [0043] * | 1,2,5-12 | |
| Y | US 2013/039098 A1 (ZHAN HUA [CN]) 14 February 2013 (2013-02-14) | 3,4 | |
| A | * figure 4 *<br>* paragraph [0063] - paragraph [0066] * | 1,2,5-12 | |

TECHNICAL FIELDS
SEARCHED (IPC)

H02M

The present search report has been drawn up for all claims

| Place of search | Date of completion of the search | Examiner |
|---|---|---|
| The Hague | 16 January 2024 | Riehl, Philippe |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 18 9712

This annex lists the patent family members relating to the patent documents cited in the above-mentioned European search report.
The members are as contained in the European Patent Office EDP file on
The European Patent Office is in no way liable for these particulars which are merely given for the purpose of information.

16-01-2024

| Patent document cited in search report | | | Publication date | Patent family member(s) | | | Publication date |
|---|---|---|---|---|---|---|---|
| US 2013300306 | A1 | | 14-11-2013 | CN | 102187737 | A | 14-09-2011 |
| | | | | DE | 112009002494 | A5 | 02-08-2012 |
| | | | | EP | 2340688 | A1 | 06-07-2011 |
| | | | | GB | 2476605 | A | 29-06-2011 |
| | | | | US | 2011254457 | A1 | 20-10-2011 |
| | | | | US | 2013300306 | A1 | 14-11-2013 |
| | | | | WO | 2010046055 | A1 | 29-04-2010 |
| US 2008130327 | A1 | | 05-06-2008 | NONE | | | |
| US 2014218978 | A1 | | 07-08-2014 | CN | 103973135 | A | 06-08-2014 |
| | | | | DE | 102014001359 | A1 | 07-08-2014 |
| | | | | US | 2014218978 | A1 | 07-08-2014 |
| US 2013039098 | A1 | | 14-02-2013 | CN | 102368667 | A | 07-03-2012 |
| | | | | US | 2013039098 | A1 | 14-02-2013 |
| | | | | WO | 2012129982 | A1 | 04-10-2012 |

For more details about this annex : see Official Journal of the European Patent Office, No. 12/82